# EUROPEAN PATENT APPLICATION

(11) **EP 3 820 034 A1**
(43) Date of publication of application: **12.05.2021**
(21) Application number: 20201265.4
(22) Date of filing: 12.10.2020
(51) Int. Cl.: H02M 1/36, H02M 1/32, H03K 17/0814, H03K 17/687, H02H 9/02, H02H 9/00

(54) **CURRENT LIMITING CIRCUIT**

(30) Priority: 08.11.2019 GB 201916243
(71) Applicant: Rolls-Royce plc, London N1 9FX (GB)
(72) Inventor: Molligoda, Devinda, Derby, Derbyshire DE24 8BJ (GB); Gajanayake, Chandana, Derby, Derbyshire DE24 8BJ (GB); Chatterjee, Pradip, Derby, Derbyshire DE24 8BJ (GB); Gupta, Amit, Derby, Derbyshire DE24 8BJ (GB)
(74) Representative: Rolls-Royce plc

(57) **Abstract**

The present disclosure concerns a current limiting circuit for a power converter, which may be used to limit charge and discharge currents for electrical power storage units. In an example embodiment, a current limiting circuit (101) comprises: first and second field effect transistors (102, 103), each having source, gate and drain connections, wherein the source connection (102s) of the first transistor (102) is connected to the gate connection (103g) of the second transistor (103) and the source connection (103s) of the second transistor (103) is connected to the gate connection (102g) of the first transistor (102); and a resistor (104) connected between the source connections (102s, 103s) of the first and second transistors (102, 103), wherein drain connections (102d, 103d) of the first and second transistors (102, 103) are connectable between a DC electrical power supply (105) and an electrical load (107) for limiting a maximum current flowing between the electrical power supply (105) and the electrical load (107).

## Description

### Field of the Disclosure

The present disclosure concerns a current limiting circuit for a power converter, which may be used to limit charge and discharge currents for electrical power storage units.

### Background

As electrical power demands for More Electric Aircraft (MEA) increase, there is an increased need for DC power distribution, electrical machines and the use of power converters capable of operating at high powers. There is also a drive towards reducing weight, which the use of Solid State Power Controllers (SSPCs), replacing electromechanical switches and circuit breakers, can contribute to. With an SSPC, the current flowing during charging and discharging of electric power storage can be controlled more flexibly, and various features such as fault detection, circuit protection and dynamic load management can be implemented through use of an electronic controller, which cannot be enabled through traditional electromechanical switches.

Devices in an SSPC require protection to remain within safe operating areas. An initial inrush current in certain loads during pre-charging should be limited, which an SSPC should be able to regulate. In aerospace applications, an SSPC is typically used in combination with a power converter and a bulk capacitor that requires pre charging and discharging, requiring currents to be limited to prevent damage. Limiting current during pre-charging and discharging may, however, require the addition of separate converters and/or other components, which can increase the component count and overall system weight.

A reversible charge limiting device may be used to limit charging and discharging currents to and from a capacitor, as for example disclosed by Alwash et al, in "Short-Circuit Protection of Power Converters with SiC Current Limiters", 2016 IEEE Energy Conversion Congress and Exposition, 18-22 September 2016, in which a pair of SiC JFETs are provided in back-to-back configuration to achieve bidirectional current limiting capability for limiting both charging (inrush) and discharging (fault) currents. Currents in such an arrangement are limited by internal features of each JFET such as channel pinch-off and self-heating, meaning that control over the current limit is a fixed device property.

### Summary

According to a first aspect there is provided a current limiting circuit comprising:
first and second field effect transistors, each having source, gate and drain connections, wherein the source connection of the first transistor is connected to the gate connection of the second transistor and the source connection of the second transistor is connected to the gate connection of the first transistor; and
a resistor connected between the source connections of the first and second transistors,
wherein drain connections of the first and second transistors are connectable between an electrical power supply and an electrical load for limiting a maximum current flowing between the electrical power supply and the electrical load.

The current limiting circuit can be used as part of a pre-charging and discharging circuit, enabling a compact and lightweight solution that can be used in combination with an SSPC. The circuit enables inrush current to be limited while allowing a bulk capacitor to be charged within a shortened pre-defined time. The circuit also enables the bulk capacitor to be discharged safely upon shutdown.

The electrical power supply may be a DC electrical power supply, for example a battery or DC electrical bus, or may in some examples be a rectified power supply.

The resistor between the first and second field effect transistors may have a resistance value of between 5 mΩ and 5 Ω. The value of the resistor determines the gate voltage of the first and second transistor, depending on the direction of current flow, and thereby determines the current limit for the circuit.

The first and second field effect transistors may be depletion mode MOSFETs or JFETs, such that the transistors are in a normally on mode, with a limiting current set by the value of the resistor provided between the source connections of the transistors.

In accordance with a second aspect there is provided an electrical power converter system comprising:
an electrical power supply;
an electrical power output connectable across an electrical power load;
a first switch between the electrical power supply and electrical power output;
a capacitor connected across the electrical power output; and
a current limiting circuit according to the first aspect connected across the switch.

The electrical power converter system may comprise a second switch arranged to connect the drain connection of the first field effect transistor to the electrical power supply in a first position for charging the capacitor and to a common connection in a second position for discharging the capacitor.

The electrical power converter system may comprise a controller configured to control operation of the electrical power supply, the switch and the current limiting circuit.

The controller may be configured, in a pre-charging mode, to operate the second switch to connect the current limiting circuit to the electrical power supply to charge the capacitor while the first switch is open, and to close the first switch after the capacitor is charged.

The controller may be configured, in the pre-charging mode, to monitor a voltage across the capacitor and report a fault if the voltage does not reach a predefined value within a predetermined timeout period.

The controller may be configured, in a discharging mode, to operate the second switch to connect the capacitor to the common connection via the current limiting circuit to discharge the capacitor.

An aircraft may comprise an electrical load connected to the electrical power converter system according to the second aspect, an advantage of which may be a reduction in component count and overall weight compared to alternative solutions.

In accordance with a third aspect there is provided a method of operating an electrical power converter system according to the second aspect, the method comprising:
in a pre-charging mode, operating the second switch to connect the current limiting circuit to the electrical power supply while the first switch is open and closing the first switch after the capacitor is charged.

In the pre-charging mode, the voltage across the capacitor may be monitored and, if the voltage does not exceed a predetermined value within a predefined timeout period, a fault may be reported.

The method may further comprise, in a discharging mode, operating the second switch to connect the capacitor to the common connection via the current limiting circuit to discharge the capacitor.

The skilled person will appreciate that except where mutually exclusive, a feature described in relation to any one of the above aspects may be applied mutatis mutandis to any other aspect. Furthermore, except where mutually exclusive, any feature described herein may be applied to any aspect and/or combined with any other feature described herein.

### Brief Description of the Drawings

Embodiments will now be described by way of example only, with reference to the Figures, in which:
**Figure 1** is a schematic circuit diagram of an example electrical power converter system comprising a current limiting circuit;
**Figure 2** is a schematic flow diagram illustrating a method of operation of the power converter system;
**Figure 3a** is a plot of current as a function of time for a conventional resistor-limited pre-charging operation;
**Figure 3b** is a plot of current as a function of time for a pre-charging operation using an example current limiting circuit;
**Figure 4** is a circuit diagram of an alternative electrical power converter system comprising a current limiting circuit; and
**Figure 5** is a circuit diagram of a further alternative electrical power converter system comprising a current limiting circuit.

### Detailed Description

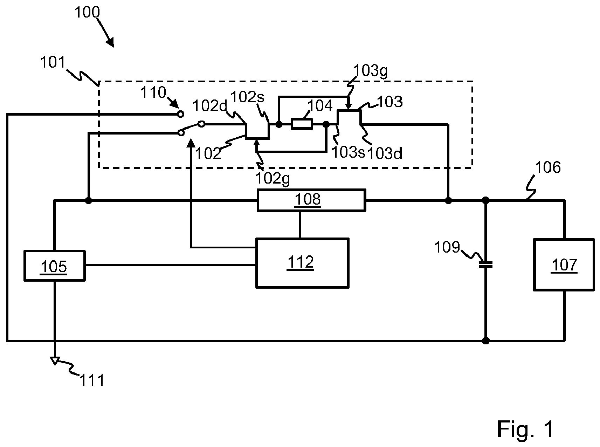

An example electrical power converter system 100 is illustrated in Figure 1. The system 100 comprises an electrical power supply 105 and an electrical load 107. The power supply 105 may be a DC electrical supply, an electrical storage unit such as a battery or a DC bus having one or more power supplies. The electrical power supply 105 may be a DC electrical supply or in alternative examples may be a rectified supply. The load 107 may be a power electronics load such as an inverter arranged to drive an electric machine and/or a resistive load. A DC link capacitor 109 is connected across a power output 106 of the system 100, i.e. across the electrical load 107. A controller 112 monitors and controls the electrical storage unit 105 and controls operation of first and second switches 108, 110. The controller 112 may also monitor the output 106, for example to determine a level of charge on the capacitor 109 during a pre-charging and/or discharging process.

In normal use, a first switch 108 connects the electrical power supply 105 to the electrical power output 106 and hence to the electrical load 107. During start-up of the system 100, however, immediately connecting the switch 108 will cause a high initial current until the capacitor 109 is sufficiently charged. Furthermore, upon shutdown of the system 100, the capacitor 109 may retain a charge that can be a safety hazard if shorted. A current limiting circuit 101 is therefore connected between the capacitor 109 and the electrical power supply 105, i.e. across the switch 108, the purpose of which is to enable charging and discharging currents to be limited upon start-up and shutdown.

The current limiting circuit 101 comprises a pair of transistors 102, 103 arranged in a back to back configuration, with the gate connection 102g of the first transistor 102 connected to the source connection 103s of the second transistor 103, and the gate connection 103g of the second transistor 103 connected to the source connection 102s of the first transistor 102. A resistor 104 is connected between the source connection 102s of the first transistor 102 and the source connection 103s of the second transistor 103. The value of the resistor 104 determines, along with the parameters of the transistors 102, 103, the maximum current flowing through the circuit 101.

The drain connection 103d of the second transistor 103 is connected to a first terminal of the capacitor 109, while a second terminal of the capacitor 109 is connected to a common (or ground) connection 111. A second switch 110 is operable between first and second positions, the first position being shown in Figure 1. In this first position, the second switch 110 connects the drain connection 102d of the first transistor 102 to the electrical power supply 105, allowing current to flow through the current limiting circuit 101 to charge the capacitor 109. Once the capacitor 109 is sufficiently charged, the first switch 108 may be closed, allowing current to flow unlimited by the circuit 101 to the electrical load 107.

Upon shutdown of the system 100, the switch 108 may be opened, leaving charge on the capacitor 109. To discharge the capacitor 109, the second switch 110 may be operated to connect the drain connection 102d to the common connection 111, causing the capacitor 109 to be discharged to ground at a rate set by the current limit of the circuit 101.

The first and second transistors 102, 103 may be depletion type MOSFETs or may be JFETs. With current flowing from the electrical power supply 105 to the load 107, the second transistor 103 is fully on and the first transistor 102 is operating in a linear region. The resistor 104 biases both transistors 102, 103, thereby minimising the component count. The resistor 104 is selected to optimise for the size and weight of the system 100 and to provide the optimum constant current for charging and discharging.

The combination of resistor and gate bias determines a constant maximum current through the circuit that is dependent on the set gate voltage. Biasing makes one of the transistors operate in its linear region, thereby making it a constant current source. As the transistors are self-biased via the resistor, a Digital Signal Processor (DSP) is not required for this task, allowing it to run a control algorithm for controlling/protecting the first and second switches 108, 110.

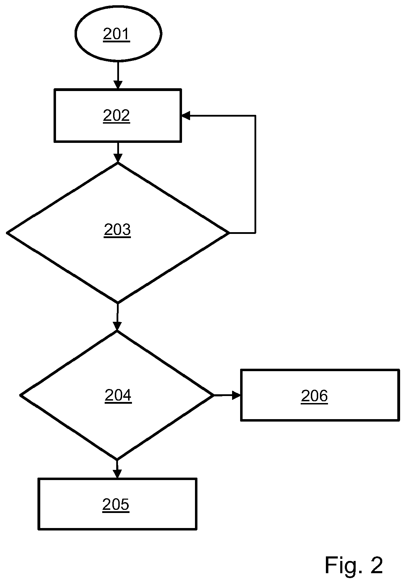

After a pre-charge period is completed, the circuit 101 is effectively bypassed by closing the first switch 108, although the circuit 101 can be left connected. If the pre-charging process takes a longer time than expected, this could indicate a fault in the output side. This feature may therefore be used as a fault detection step, enabling an opportunity to detect a short circuit fault. Figure 2 illustrates a flow chart for operation of the controller 112 to detect a fault condition. In a first step 201, the pre-charge process is started as the system is started up. The controller 112 then, in a second step 202, measures a voltage V_{cap} across the capacitor 109. In a third step 203, the controller determines whether a predetermined timeout period has elapsed. If the predetermined time period has not elapsed, step 202 repeats. The predetermined timeout period may be set by the parameters of the capacitor 109 and circuit 101, given that a capacitor of known size will charge to a given level in a known time when provided with a constant current. Once the predefined timeout period has elapsed, in a fourth step 204 the controller 112 determines whether V_{cap} has reached its specified predetermined value. If the predetermined value has been reached, the pre-charge operation completes and the controller proceeds in step 205 to normal operation, i.e. by closing switch 108 and enabling normal operation of the system 100. If the predetermined value is not reached, the controller 112 proceeds to step 206, inhibiting the pre-charge operation and/or reporting a fault.

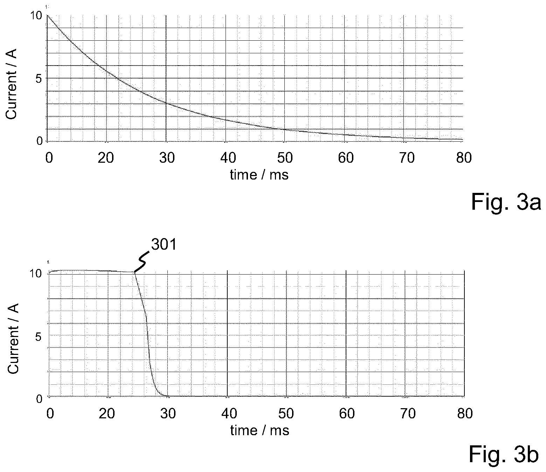

Figure 3a shows a plot of charging current as a function of time for a conventional method of limiting current, using only a resistor, where the DC bus is 270V, a maximum current is set to 10A and the capacitor is 1250µF. As expected, the charging current follows an exponential curve as the capacitor charges and the current progressively decreases. Figure 3b shows on the same scale a plot of charging current as a function of time using a current limiting circuit of the type described herein. The current is maintained at a constant level of around 10A initially, resulting in a much shorter time before the capacitor is fully charged, in this case after around 30 ms rather than around 80 ms for the conventional method. Using the current limiting circuit of the type described herein, in combination with a controller monitoring the voltage across the capacitor, allows the capacitor to be charged more quickly to a preset level, after which the main switch 108 can be closed (point 301 on the plot of Figure 3b) and the capacitor fully charged.

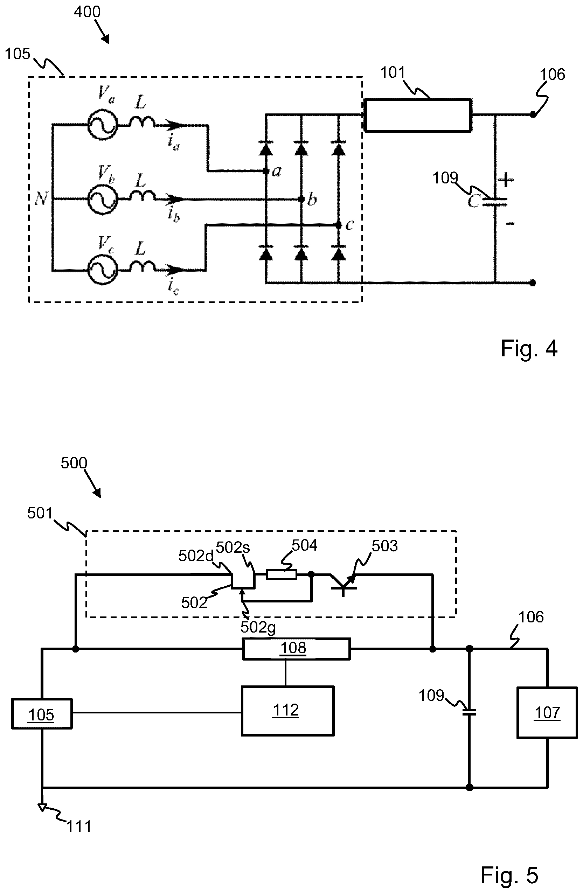

Figure 4 illustrates an alternative example system 400, in which the electrical power supply 105 comprises a three phase AC power supply and a diode bridge rectifier. Once the AC power supply is switched on, the diodes will begin conducting, causing an inrush of current to charge the capacitor 109. The current limiting circuit 101 controls this initial inrush current as with the example described above. Once the capacitor 109 has been sufficiently charged, the current limiting circuit 101 is bypassed and the system operates as normal.

Figure 5 illustrates an alternative example system 500, in which a current limiting circuit 501 is arranged to provide unidirectional current limiting for pre-charging of the capacitor 109 only. A field effect transistor 502 has its drain connection 502d connected to the electrical power supply 105 and its source connection 502s connected to a resistor 504. The gate connection 502g is connected to the source connection 502s via the resistor 504. A transistor switch 503 is connected in series with the FET 502 to activate the current limiting circuit 501. The system 500 operates in the same way as the system 100 described above, but is configured only for unidirectional operation during pre-charging.

In summary, the circuit described herein is able to support bidirectional constant current flow and can therefore be used for both pre-charging and discharging. The constant current enables a lightweight design and enables inrush current limiting compared to conventional methods. Pre-charging can thereby be achieved in a more controlled way and within a pre-defined time to achieve faster pre-charging rates, as well as faster discharging rates. The constant current pre-charging also enables early short circuit fault detection.

Embodiments of the present disclosure may be described with reference to the following numbered clauses. Optional features are provided in the dependent clauses.
1. A current limiting circuit (101) comprising:
   first and second field effect transistors (102, 103), each having source, gate and drain connections, wherein the source connection (102s) of the first transistor (102) is connected to the gate connection (103g) of the second transistor (103) and the source connection (103s) of the second transistor (103) is connected to the gate connection (102g) of the first transistor (102); and
   a resistor (104) connected between the source connections (102s, 103s) of the first and second transistors (102, 103),
   wherein drain connections (102d, 103d) of the first and second transistors (102, 103) are connectable between an electrical power supply (105) and an electrical load (107) for limiting a maximum current flowing between the electrical power supply (105) and the electrical load (107).
2. The current limiting circuit (101) of clause 1 wherein the resistor (104) has a resistance value of between 5 mΩ and 5 Ω.
3. The current limiting circuit (101) of clause 1 or clause 2 wherein the first field effect transistor (102) and/or the second field effect transistor (103) is a depletion mode MOSFET or a JFET.
4. An electrical power converter system (100) comprising:
   an electrical power supply (105);
   an electrical power output (106) connectable across an electrical power load (107);
   a first switch (108) between the electrical power supply (105) and electrical power output (106);
   a capacitor (109) connected across the electrical power output (106); and
   a current limiting circuit (101) according to any preceding clause connected across the switch (108).
5. The electrical power converter system (100) of clause 4 comprising a second switch (110) arranged to connect the drain connection (102d) of the first field effect transistor (102) to the electrical power supply (105) in a first position for charging the capacitor (109) and to a common connection (111) in a second position for discharging the capacitor (109).
6. The electrical power converter system (100) of clause 5 comprising a controller (112) configured to control operation of the electrical power supply (105), the switch (108) and the current limiting circuit (101).
7. The electrical power converter system (100) of clause 6 wherein the controller (112) is configured, in a pre-charging mode, to operate the second switch (110) to connect the current limiting circuit (101) to the electrical power supply (105) to charge the capacitor (109) while the first switch (108) is open, and to close the first switch (108) after the capacitor (109) is charged.
8. The electrical power converter system (100) of clause 7 wherein the controller (112) is configured, in the pre-charging mode, to monitor a voltage across the capacitor (109) and report a fault if the voltage does not reach a predefined value within a predetermined timeout period.
9. The electrical power converter system (100) of clause 6, clause 7 or clause 8 wherein the controller (112) is configured, in a discharging mode, to operate the second switch (110) to connect the capacitor (109) to the common connection (111) via the current limiting circuit (101) to discharge the capacitor (109).
10. An aircraft comprising an electrical load (107) connected to the electrical power converter system (100) of any preceding clause.
11. A method of operating an electrical power converter system (100) according to any one of clauses 5 to 9, the method comprising:
   in a pre-charging mode, operating the second switch (110) to connect the current limiting circuit (101) to the electrical power supply (105) while the first switch (108) is open and closing the first switch (108) after the capacitor (109) is charged.
12. The method of clause 11, wherein in the pre-charging mode a voltage across the capacitor (109) is monitored and, if the voltage across the capacitor (109) does not exceed a predetermined value within a predefined timeout period, a fault is reported.
13. The method of clause 11 or clause 12 comprising, in a discharging mode, operating the second switch (110) to connect the capacitor (109) to the common connection (111) via the current limiting circuit (101) to discharge the capacitor (109).

It will be understood that the invention is not limited to the embodiments above-described and various modifications and improvements can be made without departing from the concepts herein. Except where mutually exclusive, any of the features may be employed separately or in combination with any other features and the disclosure extends to and includes all combinations and sub-combinations of one or more features described herein.

## Claims

1. An electrical power converter system (100) comprising a bi-directional pre-charging and discharging current limiting circuit (101) for limiting charging and discharging currents upon start-up and shutdown of the system (100), the system (100) further comprising:
an electrical power supply (105);
an electrical power output (106) connectable across an electrical power load (107);
a first switch (108) between the electrical power supply (105) and electrical power output (106); and
a capacitor (109) connected across the electrical power output (106),
wherein the current limiting circuit (101) is connected across the first switch (108) and comprises: first and second field effect transistors (102, 103), each having source, gate and drain connections, wherein the source connection (102s) of the first transistor (102) is connected to the gate connection (103g) of the second transistor (103) and the source connection (103s) of the second transistor (103) is connected to the gate connection (102g) of the first transistor (102); and a resistor (104) connected between the source connections (102s, 103s) of the first and second transistors (102, 103), and
wherein drain connections (102d, 103d) of the first and second transistors (102, 103) are connectable between the electrical power supply (105) and the electrical load (107) for limiting a maximum current flowing upon start-up and shutdown of the system (100).

2. The electrical power converter system (100) of claim 1 wherein the resistor (104) has a resistance value of between 5 mΩ and 5 Ω.

3. The electrical power converter system (100) of claim 1 or claim 2 wherein the first field effect transistor (102) and/or the second field effect transistor (103) is a depletion mode MOSFET or a JFET.

4. The electrical power converter system (100) of any one of the preceding claims, wherein the resistor (104) is a single resistor that biases both of the first and second transistors (102, 103).

5. The electrical power converter system (100) of any one of the preceding claims comprising a second switch (110) arranged to connect the drain connection (102d) of the first field effect transistor (102) to the electrical power supply (105) in a first position for charging the capacitor (109) and to a common connection (111) in a second position for discharging the capacitor (109).

6. The electrical power converter system (100) of claim 5 comprising a controller (112) configured to control operation of the electrical power supply (105), the first switch (108) and the current limiting circuit (101).

7. The electrical power converter system (100) of claim 6 wherein the controller (112) is configured, in a pre-charging mode, to operate the second switch (110) to connect the current limiting circuit (101) to the electrical power supply (105) to charge the capacitor (109) while the first switch (108) is open, and to close the first switch (108) after the capacitor (109) is charged.

8. The electrical power converter system (100) of claim 7 wherein the controller (112) is configured, in the pre-charging mode, to monitor a voltage across the capacitor (109) and report a fault if the voltage does not reach a predefined value within a predetermined timeout period.

9. The electrical power converter system (100) of claim 6, claim 7 or claim 8 wherein the controller (112) is configured, in a discharging mode, to operate the second switch (110) to connect the capacitor (109) to the common connection (111) via the current limiting circuit (101) to discharge the capacitor (109).

10. The electrical power converter system (100) of any one of the preceding claims, wherein the electrical power supply (105) is a DC electrical bus.

11. An aircraft propulsion system comprising the electrical power converter system (100) of any preceding claim.

12. An aircraft comprising an electrical load (107) connected to the electrical power converter system (100) of any one of claims 1 to 10.

13. A method of operating an electrical power converter system (100) according to any one of claims 1 to 10, the method comprising:
in a pre-charging mode, operating the second switch (110) to connect the current limiting circuit (101) to the electrical power supply (105) while the first switch (108) is open and closing the first switch (108) after the capacitor (109) is charged.

14. The method of claim 13, wherein in the pre-charging mode a voltage across the capacitor (109) is monitored and, if the voltage across the capacitor (109) does not exceed a predetermined value within a predefined timeout period, a fault is reported.

15. The method of claim 13 or claim 14 comprising, in a discharging mode, operating the second switch (110) to connect the capacitor (109) to the common connection (111) via the current limiting circuit (101) to discharge the capacitor (109).
